# EUROPEAN PATENT SPECIFICATION

(11) **EP 2 043 148 B1**
(45) Date of publication and mention of the grant of the patent: **28.12.2011**
(21) Application number: 08164209.2
(22) Date of filing: 12.09.2008
(51) Int. Cl.: H01L 23/367

(54) **Thermal-dissipating device**
Wärmeableitungsvorrichtung
Dispositif de dissipation thermique

(30) Priority: 29.09.2007 TW 96136632
(43) Date of publication of application: 01.04.2009
(73) Proprietor: Kuo, Ching-Sung, Taipei County 236 (TW)
(72) Inventor: Kuo, Ching-Sung, Taipei County 236 (TW)
(74) Representative: 2K Patentanwälte Blasberg Kewitz & Reichel

(56) References cited:
- EP-A- 1 328 019
- WO-A-2007/102710
- DE-U1-202006 017 531
- US-A- 6 009 937
- US-A1- 2001 010 264
- US-A1- 2002 148 603

## Description

### BACKGROUND OF THE INVENTION

### FIELD OF INVENTION

The invention relates to a thermal-dissipating device.
The present application claims priority under Art. 87 EPC from Taiwanese Patent Application No. 096136632, filed on September 29, 2007 in Taiwan (R.O.C), the whole content of is hereby incorporated by reference.

### RELATED ART

Recently, the electronic products usually have high performance, high operating frequencies, high speeds, and more compact sizes. However, they also generate more heat that may result in instability of the electronic products. The instability can affect the reliability and lifetime of the electronic products. Therefore, heat dissipation has become an important issue of electronic products, and thermal-dissipating devices are commonly used for dissipating heat.

US2001/0010264 discloses a heat dissipating device including a plurality of heat dissipating plates. Each of the heat dissipating plates has a stack plate portion and at least one fin plate portion that extends integrally from the stack plate portion. The stack plate portions of the heat dissipating plates are in close contact with one another and cooperatively form a stack part with a flat contact face adapted to be placed on a heat generating article. The fin plate portions of the heat dissipating plates are bent from the stack plate portions to extend divergingly away from the stack part. The fin plate portions have confronting surfaces which diverge away from one another.

US2002/0148603 discloses a heat dissipating device including a plurality of plates each having a three-sided base plate portion and a pair of fin plate portions. The base plate portion has a contact side adapted to contact a heat generating object, and two opposite sides forming an angle therebetween and extending to two opposite ends of the contact side. The base plate portions of the plates are disposed in parallel and next to each other to form a stack. The fin plate portions respectively extend outward from the opposite sides of the base plate portions and are bent from the base plate portions to diverge outward and to form air passages therebetween.

A conventional thermal-dissipating device has a plurality of thermal-dissipating sheets connecting with each other. Each of the thermal-dissipating sheets has a connecting portion and a thermal-dissipating fin. The thermal-dissipating fin is extended outwardly from one side of the connecting portion. During the assembling process, the thermal-dissipating sheets are connected side by side and then spread out from each other so as to form a thermal-dissipating device. Thus, there is a space between the thermal-dissipating fins of the thermal-dissipating sheets. When the connecting portions of the thermal-dissipating device are in touch with a heat source, the heat can be transferred via the connecting portions to the thermal-dissipating fins. The air conduction and convection can then help to remove the heat. However, the structure of the conventional thermal-dissipating device limits its design, and thus no new design of the thermal-dissipating device is invented recently.

Therefore, it is an important subject of the invention to provide a thermal-dissipating device that has a novel design that can render a wider market and more applications.

### SUMMARY OF THE INVENTION

In view of the foregoing, the invention is to provide a thermal-dissipating device that has a novel design that can render a wider market and more applications.

To achieve the above, the invention discloses a thermal-dissipating device formed by connecting a plurality of thermal-dissipating sheets. Each of the thermal-dissipating sheets includes a plurality of connecting portions and a plurality of thermal-dissipating fins. The connecting portions are connected with each other, and the thermal-dissipating fins are connected with the connecting portion, respectively. At least one set of the thermal-dissipating fins are connected with each other.

To achieve the above, the invention also discloses a thermal-dissipating device formed by continuously bending at least one thermal-dissipating sheet to render a plurality of bending sections. Each of the bending sections includes a connecting portion and at least one thermal-dissipating fin. The connecting potions are connected with each other. The thermal-dissipating fin is connected with the connecting portion, and the thermal-dissipating fins are connected with each other by at least one end.

As mentioned above, the thermal-dissipating device of the invention can have several different design aspects. For example, the thermal-dissipating sheets are bent once before they are stacked together or covered within each other. Alternatively, the thermal-dissipating sheets can be bent several times before they are stacked together or covered within each other. In comparison with the related art, the invention provides versatile designs that can increase the applicability and potential market.

### BRIEF DESCRIPTION OF THE DRAWINGS

The invention will become more fully understood from the detailed description and accompanying drawings, which are given for illustration only, and thus are not limitative of the present invention, and wherein:

FIG. 1A is a schematic view of a thermal-dissipating device according to a first embodiment of the invention;

FIG. 1B is a schematic view of the thermal-dissipating sheet in FIG. 1A;

FIG. 1C is a schematic view showing a variation aspect of the thermal-dissipating device in FIG. 1A;

FIG. 2 is a schematic view of a thermal-dissipating device according to a second embodiment of the invention;

FIG. 3 is a schematic view of a thermal-dissipating device according to a third embodiment of the invention;

FIGS. 4A and 4B are schematic views of a thermal-dissipating device according to a fourth embodiment of the invention;

FIG. 5 is a schematic view of a thermal-dissipating device according to a fifth embodiment of the invention;

FIG. 6 is a schematic view of a thermal-dissipating device according to a sixth embodiment of the invention;

FIG. 7 is a schematic view of a thermal-dissipating device according to a seventh embodiment of the invention;

FIG. 7A is a schematic view of one of the thermal-dissipating sheets in FIG. 7;

FIG. 8 is a schematic view of a thermal-dissipating device according to an eighth embodiment of the invention;

FIG. 9 is a schematic view of a thermal-dissipating device according to a ninth embodiment of the invention;

FIGS. 10A and 10B are schematic views of a thermal-dissipating device according to a tenth embodiment of the invention;

FIG. 11 is a schematic view of a thermal-dissipating device according to an eleventh embodiment of the invention;

FIG. 11A is a schematic view of another thermal-dissipating device according to the eleventh embodiment of the invention;

FIG. 12 is a schematic view of a thermal-dissipating device according to a twelfth embodiment of the invention;

FIG. 13 is a schematic view of a thermal-dissipating device according to a thirteenth embodiment of the invention; and

FIG. 14 is a schematic view of a thermal-dissipating device according to a fourteenth embodiment of the invention.

### DETAILED DESCRIPTION OF THE INVENTION

The present invention will be apparent from the following detailed description, which proceeds with reference to the accompanying drawings, wherein the same references relate to the same elements.

### First embodiment: single-folded and single-sided

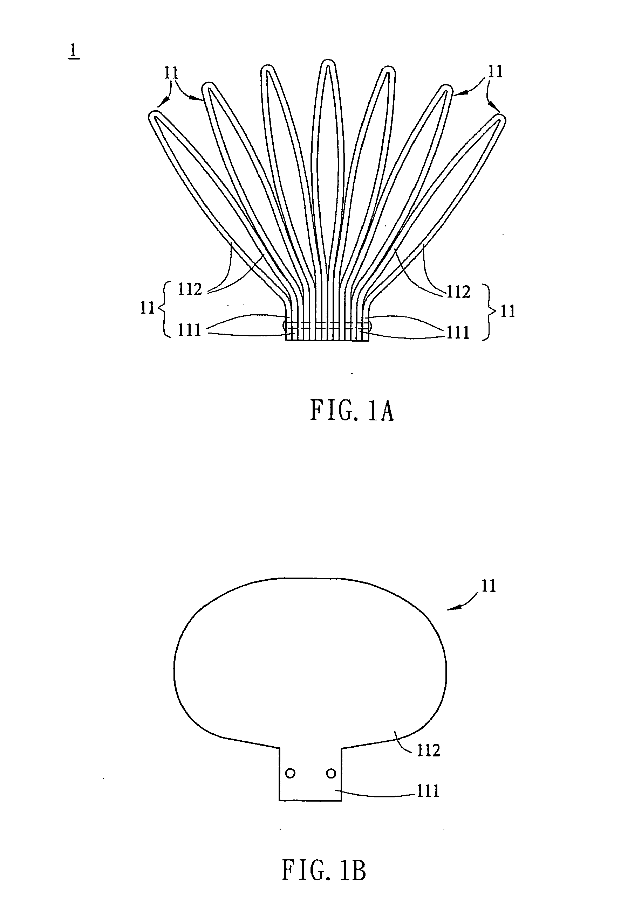

FIG. 1A is a side view of the thermal-dissipating device 1 according to a first embodiment of the invention. The thermal-dissipating device 1 includes a plurality of thermal-dissipating sheets 11, each of which has two connecting portions 111 and two thermal-dissipating fins 112. The connecting portions 111 are located on two ends of the thermal-dissipating sheet 11. The thermal-dissipating fins 112 are connected with the connecting portions 111, respectively, and extended from the connecting portions 111 outwards. The connecting portions 111 are connected with each other by screwing or riveting. This embodiment uses the riveting connection as an example. At least one set of the thermal-dissipating fins 112 are connected with each other.

As shown in FIG. 1A, the thermal-dissipating device 1 has, for example but not limited to, seven sets of thermal-dissipating fins 112, and each set includes two thermal-dissipating fins 112. In practice, the thermal-dissipating fins 112 can be formed by bending a long stripe of thermal-dissipating sheet 11. That is, the thermal-dissipating sheet 11 can be a single-folded sheet.

In this embodiment, the shape, size and material of the thermal-dissipating sheets 11 can be the same or different. Besides, the thermal-dissipating sheets 11 can be disposed side by side along the same or different directions. Of course, the thermal-dissipating sheets 11 can also be disposed in a crisscross way.

FIG. 1B is a side view of the thermal-dissipating sheets 11 in the thermal-dissipating device 1 (from different side). Regarding to the thermal-dissipating sheet 11, the area of the thermal-dissipating fin 112 can be larger than that of the connecting portion 111 for increasing the area for dissipating heat and thus enhancing the thermal-dissipating efficiency.

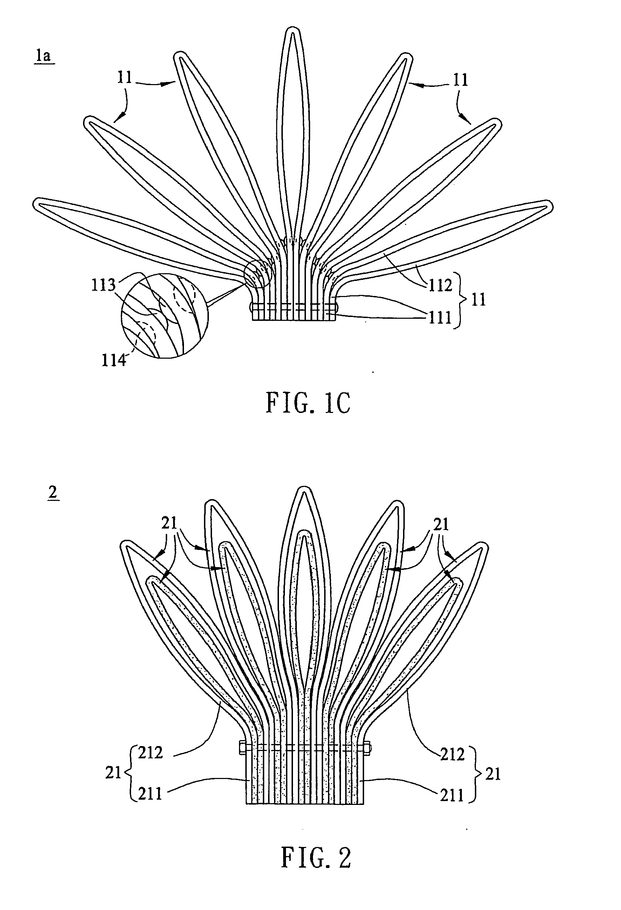

FIG. 1C is a side view of a variation aspect of the thermal-dissipating device 1 in FIG. 1A. The difference between the thermal-dissipating device 1 and the thermal-dissipating device 1a is in that the thermal-dissipating sheet 11 of the thermal-dissipating device 1a has the protrusions 113. Since the protrusions 113 of the adjacent thermal-dissipating sheets 11 are contacted against each other, the space between the adjacent thermal-dissipating sheets 11 can be further increased, thereby improving the airflow guiding effect. That is, the airflow can pass through the increased space between the adjacent thermal-dissipating sheets 11, which is formed by the protrusions 113, so that the thermal-dissipating effect can be enhanced.

The position of the protrusion 113 is not limited. For example, the protrusion 113 can be disposed on the connecting portions 111 or the thermal-dissipating fins 112. In addition, it can also be disposed on one thermal-dissipating fin 112 or two thermal-dissipating fins 112 of the thermal-dissipating sheet 11. The adjacent protrusions 113 can be disposed corresponding to each other or misaligned with each other. The shape of the protrusion 113 is not limited and can be arc-shaped, stripe-shaped, block-shaped or other shape or their combinations. The number of the protrusion 113 is not limited. For example, each thermal-dissipating sheet 11 may include one or more protrusion 113, or some of the thermal-dissipating sheets 11 do not have the protrusion 113. The forming method of the protrusion 113 is also not limited. For example, the protrusion 113 can be an additional member attached to the thermal-dissipating sheet 11 or integrally formed on the thermal-dissipating sheet 11 by stamping. In the embodiment, the thermal-dissipating sheet 11 may further include a recess 114 disposed corresponding to the protrusion 113. To be noted, the technical feature of the protrusion 113 can be applied to any of the thermal-dissipating devices described hereinbelow, so the descriptions thereof will be omitted.

### Second embodiment: single-folded, double-layered, and single-sided

FIG. 2 is a side view of a thermal-dissipating device 2 according to the second embodiment of the invention. The difference between this thermal-dissipating device 2 and the thermal-dissipating device 1 in the first embodiment is that the thermal-dissipating sheets 21 of the thermal-dissipating device 2 are combined to provide a double-layered structure. In this embodiment, two thermal-dissipating sheets 21 of different sizes are disposed along the same direction to form a set of double-layered thermal-dissipating sheets 21. Several sets of thermal-dissipating sheets 21 are then stacked and connected by, for example, screwing. Of course, they can be disposed along different directions as well.

### Third embodiment: single-folded, double-layered, and double-sided

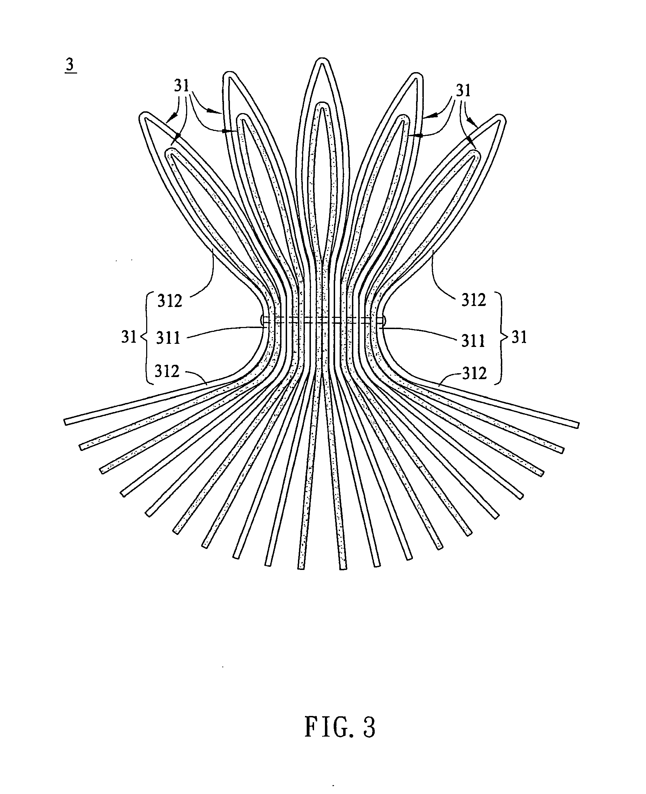

FIG. 3 is a top view of a thermal-dissipating device 3 according to the third embodiment of the invention. The difference between the thermal-dissipating device 3 and the thermal-dissipating device 2 is that the connecting portion 311 of the thermal-dissipating sheet 31 in the thermal-dissipating device 3 is located at the central portion of the thermal-dissipating sheet 31. The thermal-dissipating sheets 31 are further bent one more time before they are connected so as to form a double-sided, double-layered structure.

### Fourth embodiment: single-folded, single-layered, double-sided, and one-large-and-one-small

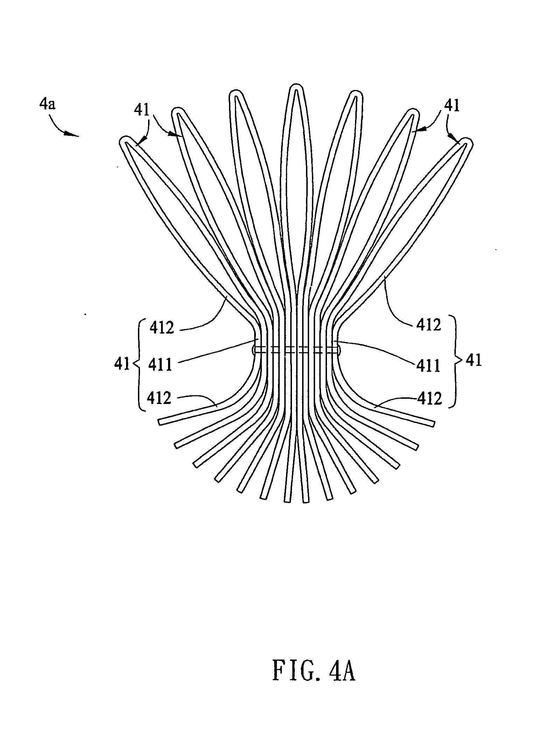

FIG. 4A is a top view of a thermal-dissipating device 4a according to the fourth embodiment of the invention. The difference between the thermal-dissipating device 4a and the thermal-dissipating device 1 is that the connecting portion 411 of the thermal-dissipating sheet 41 in the thermal-dissipating device 4a is located between one end of the thermal-dissipating sheet 41 and its center, thereby forming a one-large-and-one-small double-sided structure. The term "one-large-and-one-small" refers herein to the configuration that the sizes of the portions of the thermal-dissipating sheet 41 disposed on two sides of the connecting portion 411 are different.

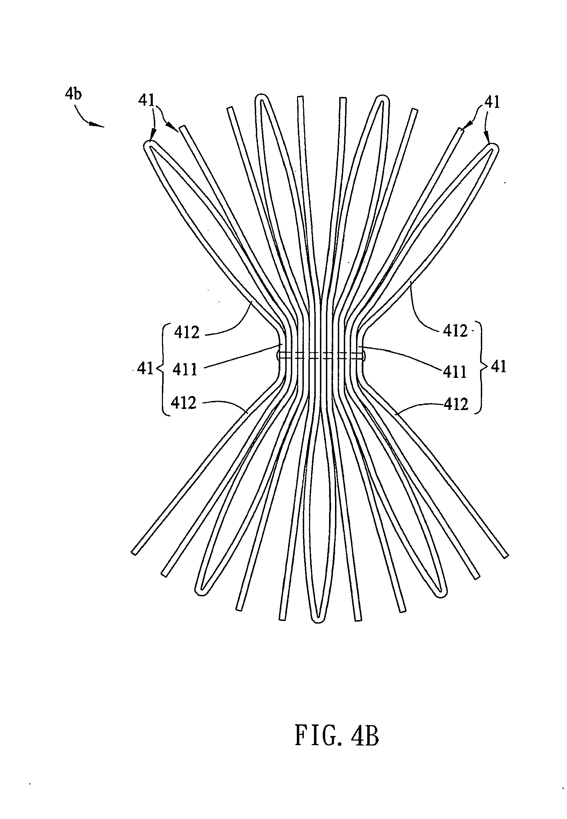

FIG. 4B is a top view of a thermal-dissipating device 4b, which is a variation of the thermal-dissipating device 4a. In thermal-dissipating device 4a, every two of the thermal-dissipating fins 412 disposed at one side of the connecting portion 411 are connected, and the thermal-dissipating fins 412 disposed at the other side of the connecting portion 411 are not connected. In thermal-dissipating device 4b, two of some of the thermal-dissipating fins 412 disposed at one side of the connecting portion 411 are connected, and the other thermal-dissipating fins 412 are not connected. In addition, the thermal-dissipating device 4b is not the one-large-and-one-small structure, and the thermal-dissipating sheets 41 disposed at two sides of the connecting portion 411 can have substantially the same size.

### Fifth embodiment: single-folded, double-layered, double-sided, and one-large-and-one-small

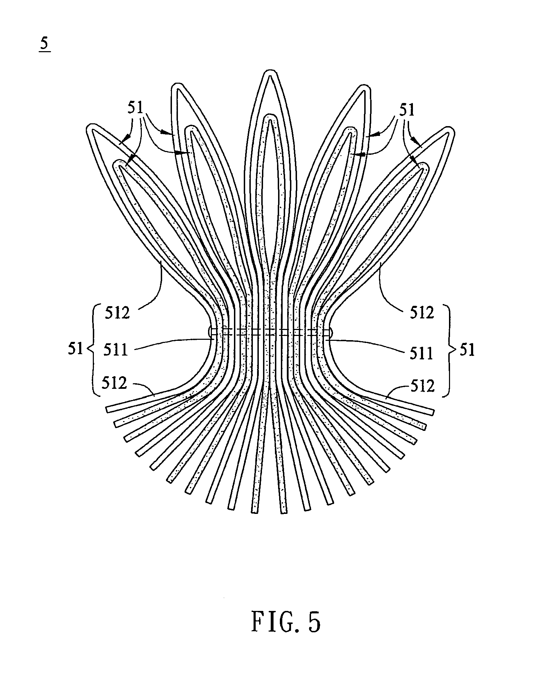

FIG. 5 is a top view of a thermal-dissipating device 5 according to the fifth embodiment of the invention. The difference between the thermal-dissipating device 5 and the thermal-dissipating device 3 is that the connecting portion 511 of the thermal-dissipating sheet 51 in the thermal-dissipating device 5 is located between one end of the thermal-dissipating sheet 51 and its center, thereby forming a one-large-and-one-small double-layered structure.

### Sixth embodiment: double-folded and double-sided

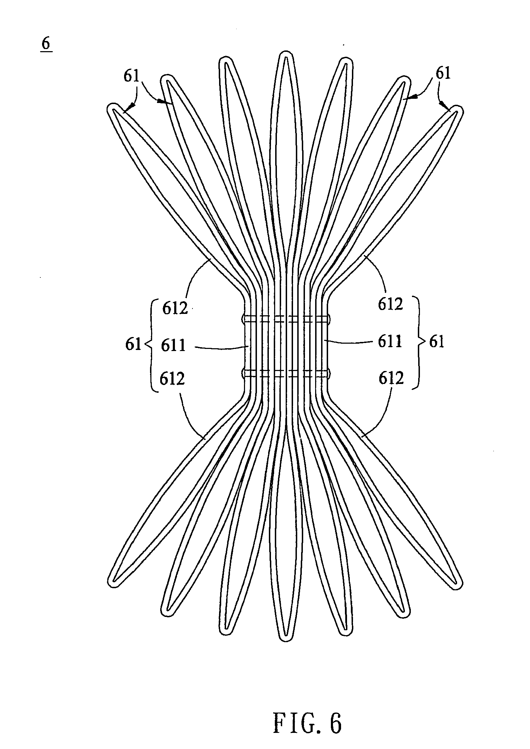

FIG. 6 is a top view of a thermal-dissipating device 6 according to the sixth embodiment of the invention. The difference between the thermal-dissipating device 6 and the thermal-dissipating device 4 is that four thermal-dissipating fins 612 are disposed at two sides of the thermal-dissipating sheet 61, and every two thermal-dissipating fins 612 disposed at the same side are connected with each other. Thus, each of the thermal-dissipating sheets 61 can be viewed as a sheet with double folding. The thermal-dissipating sheets 61 are further stacked together through their connecting portions 611. In practice, two ends of a stripe sheet can be connected to form the thermal-dissipating sheet 61 with double folding.

### Seventh embodiment: double-folded, double-layered, and double-sided

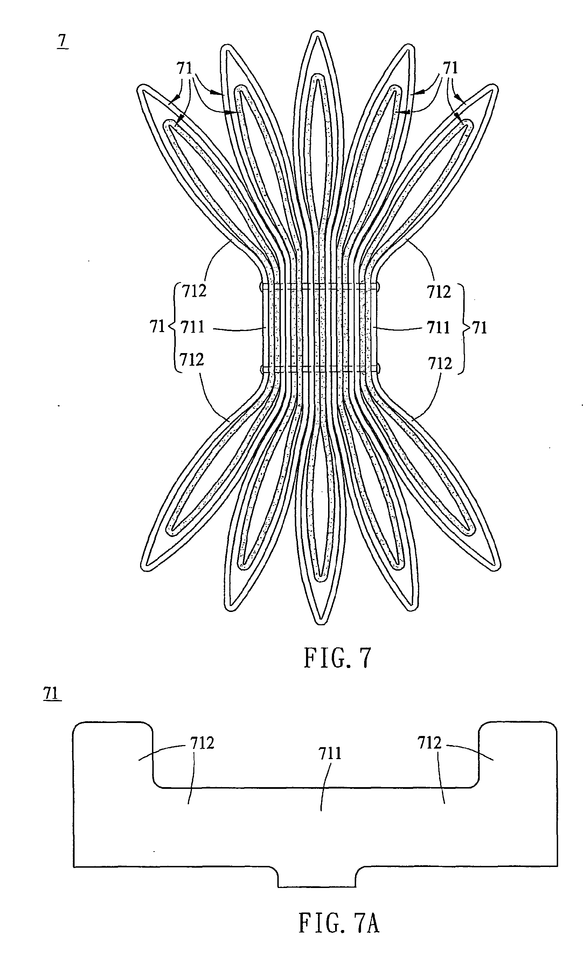

FIG. 7 is a top view of a thermal-dissipating device 7 according to the seventh embodiment of the invention. The difference between the thermal-dissipating device 7 and the thermal-dissipating device 3 is that four thermal-dissipating fins 712 are disposed at two sides of the thermal-dissipating sheet 71, and every two thermal-dissipating fins 712 disposed at the same side are connected with each other. Thus, each thermal-dissipating sheet 71 can be viewed as a sheet with double folding. Two thermal-dissipating sheets 71 of different sizes are then combined to form a set of double-layered thermal-dissipating sheets 71. Several sets of such thermal-dissipating sheets 71 are then stacked together. In this embodiment, the connecting portion 711 of the thermal-dissipating sheet 712 is disposed at the center of the thermal-dissipating sheet 71, so that a double-folded, double-layered, and double-sided structure is obtained.

FIG. 7A is a side view of the thermal-dissipating sheet 71 in the thermal-dissipating device 7. To enhance the thermal-dissipating efficiency, the top edge of the thermal-dissipating fin 712 of each thermal-dissipating sheet 71 can be higher than that of the connecting portion 711, and the area of the thermal-dissipating fin 712 can be larger than that of the connecting portion 711. Besides, the bottom edge of the connecting portion 711 of each thermal-dissipating sheet 71 protrudes relative to the bottom edge of the thermal-dissipating fin 712 for direct contact with the heat source (such as a processing chip).

### Eighth embodiment: double-folded, double-layered, double-sided, and one-large-and-one-small

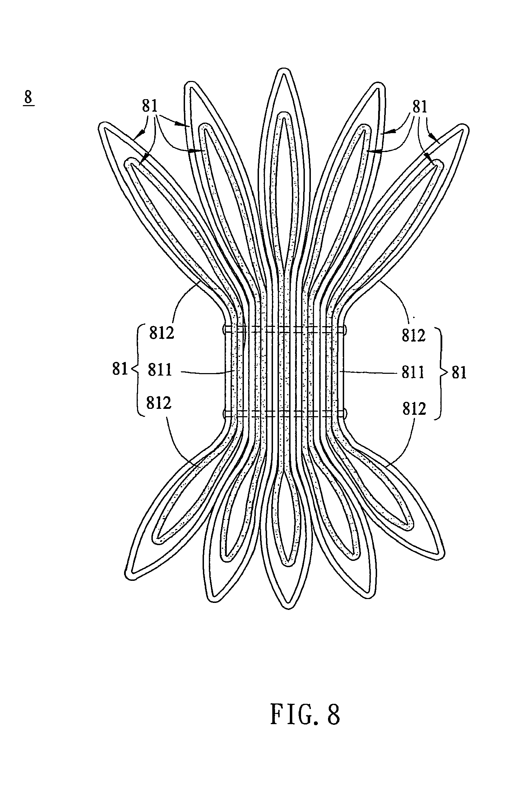

FIG. 8 is a top view of a thermal-dissipating device 8 according to the eighth embodiment of the invention. The difference between the thermal-dissipating device 8 and the thermal-dissipating device 7 is that the connecting portion 811 of the thermal-dissipating sheet 81 in the thermal-dissipating device 8 is located between one end of the thermal-dissipating sheet 81 and its center, forming a one-large-and-one-small double-layered structure.

### Ninth embodiment: double-folded or single-folded, double-sided, and one-large-and-one-small

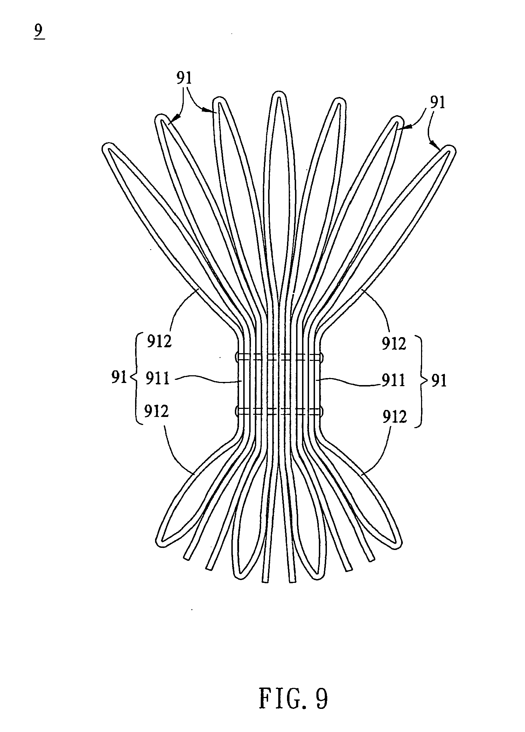

FIG. 9 is a top view of a thermal-dissipating device 9 according to the ninth embodiment of the invention. The thermal-dissipating device 9 includes several thermal-dissipating sheets 91 connected together. The thermal-dissipating sheets 91 include two aspects. In the first aspect, two thermal-dissipating fins 912 on one side of the thermal-dissipating sheet 91 are connected together (similar to the thermal-dissipating sheet 41 of FIG. 4). In the second aspect, every two thermal-dissipating fins 912 disposed at the same side are connected with each other (similar to the thermal-dissipating sheet 61 of FIG. 6). In this embodiment, the thermal-dissipating sheets 91 of the first aspect and the thermal-dissipating sheets 91 of the second aspect are alternately arranged. In addition, the connecting portion 911 is located between one end of the thermal-dissipating sheet 91 and its center, thereby forming a one-large-and-one-small double-sided structure.

### Tenth embodiment: double-folded, single-layered, and triple-sided

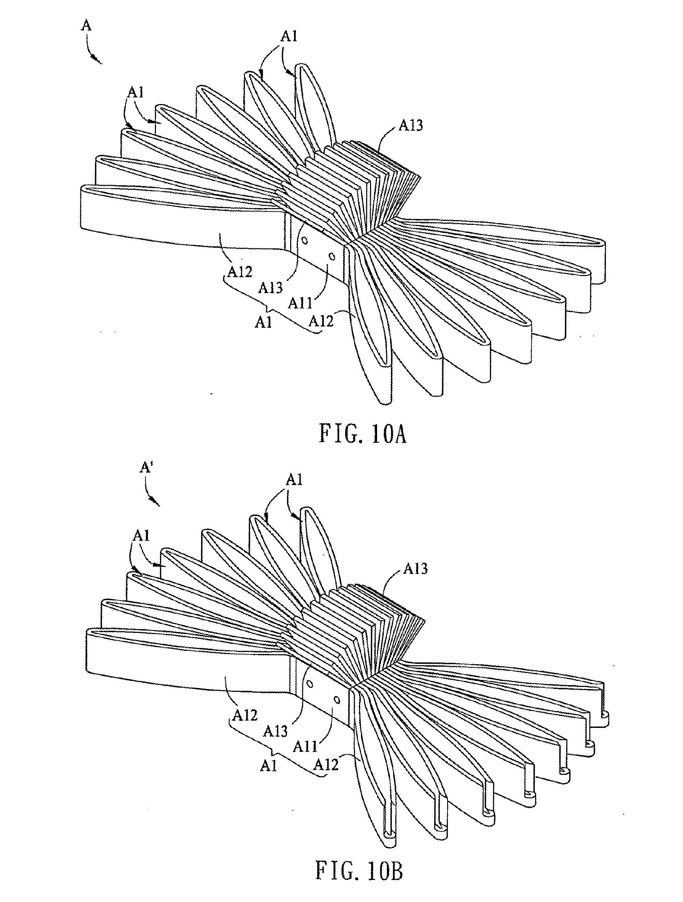

FIG. 10A is a three-dimensional view of a thermal-dissipating device A. The thermal-dissipating device A is formed by connecting several thermal-dissipating sheets A1. Each thermal-dissipating sheet A1 has two connecting portions A11, four thermal-dissipating fins A12, and two thermal-dissipating portions A13. Two thermal-dissipating fins A12 and one thermal-dissipating portion A13 extend outwards from one connecting portion A11. The thermal-dissipating fins A12 on the same side of the thermal-dissipating sheet A1 are connected with each other, forming a double-folded sheet. The thermal-dissipating portions A13 are spread out to increase the thermal-dissipating area, thus increasing the thermal-dissipating efficiency.

In addition, FIG. 10B is a three-dimensional view of a thermal-dissipating device A', which is a variation of the thermal-dissipating device A. In thermal-dissipating device A, the thermal-dissipating fins A12 disposed at one side of the connecting portion A11 are completely connected. In thermal-dissipating device A', the thermal-dissipating fins A12 disposed at one side of the connecting portion A11 are connected with an opening, so that the thermal-dissipating fins A12 are partially connected so as to achieve an airflow guiding effect. That is, the airflow can enter the space between two thermal-dissipating fins A12 through the opening, thereby improving the heat-dissipating effect. As shown in FIG. 10B, the openings are disposed between the thermal-dissipating fins A12 at only one side of the connecting portion A11. Of course, the openings can be disposed between the thermal-dissipating fins A12 at both sides of the connecting portion A11. In addition, the shape of the opening can be, for example but not limited to, V-shaped, U-shaped, W-shaped, Y-shaped or other shape. The depth of the opening can be one-fourth, one-third or one half of the connection part between the thermal-dissipating fins A12.

### Eleventh embodiment: continuously-folded and double-sided

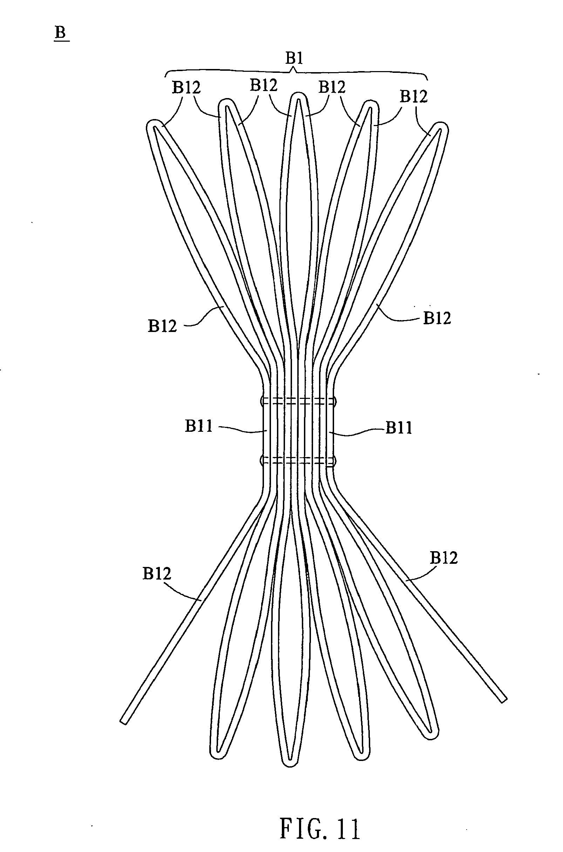

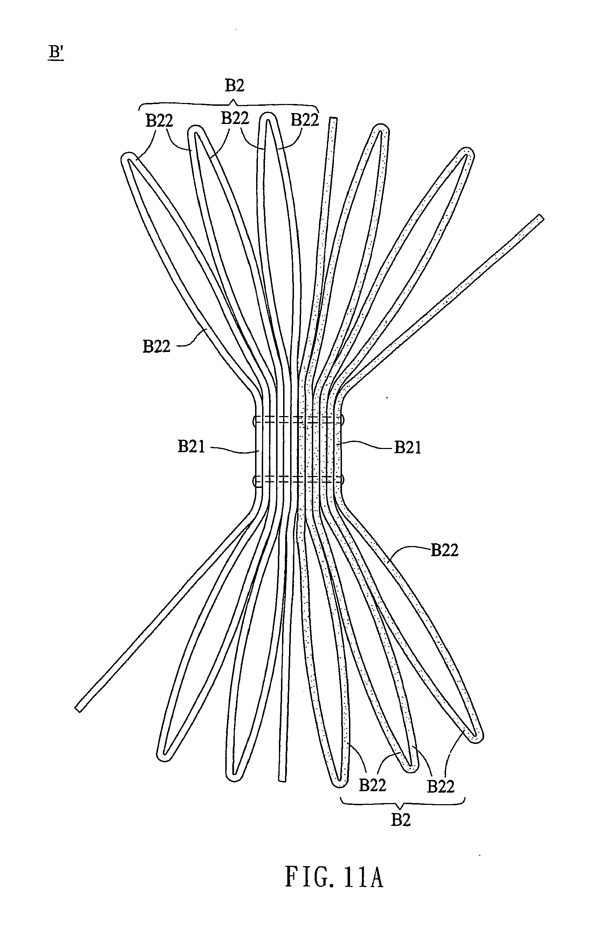

FIG. 11 is a top view of a thermal-dissipating device B according to the eleventh embodiment of the invention. The thermal-dissipating device B has several bending sections formed by continuously bending at least one thermal-dissipating sheet B1. Each bending section includes one connecting portion B11 and at least one thermal-dissipating fin B12. Each of the connecting portions B11 is disposed at the center of the corresponding bending section B1. The connecting portions B11 are connected with each other by, for example, screwing or riveting. Each of the thermal-dissipating fins B12 is connected with the corresponding connecting portion B11. The continuous two thermal-dissipating fins B12 are connected with each other.

Besides, in this embodiment, the top edge of the thermal-dissipating fin B12 of the thermal-dissipating sheet B1 can be higher than that of the connecting portion B11 (similar to the thermal-dissipating fin 712 and the connecting portion 711 of FIG. 7A), and the area of the thermal-dissipating fin B12 can be larger than that of the connecting portion B11. Moreover, the bottom edge of the connecting portion B11 of each thermal-dissipating sheet B1 protrudes relative to the bottom edge of the thermal-dissipating fin B12 for direct contact with the heat source (such as a processing chip).

If the connecting portion B11 of each bending section is located on one end thereof, then it forms the continuously-folded and single-sided aspect.

FIG. 11A shows a thermal-dissipating device B' formed by continuously bending two thermal-dissipating sheets B2 that are disposed side by side. The two thermal-dissipating sheets B2 are disposed along different directions and connected by, for example, screwing or riveting. The thermal-dissipating sheets B2 can also be disposed in the same direction, and can be connected side by side, in a crisscross way, or covered within each other.

### Twelfth embodiment: continuously-folded, double-sided, and one-large-and-one-small

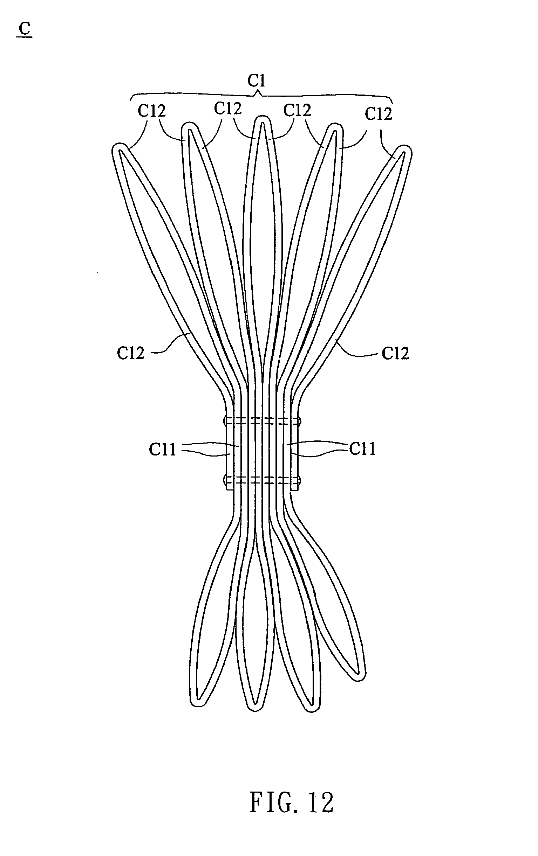

FIG. 12 is a top view of a thermal-dissipating device C according to the twelfth embodiment of the invention. The thermal-dissipating device C and the thermal-dissipating device B are different in that the connecting portion C11 of the thermal-dissipating sheet C1 in the thermal-dissipating device C is disposed between one end of the bending section and its center, forming a one-large-and-one-small double-sided structure.

### Thirteenth embodiment: continuously-folded and triple-sided

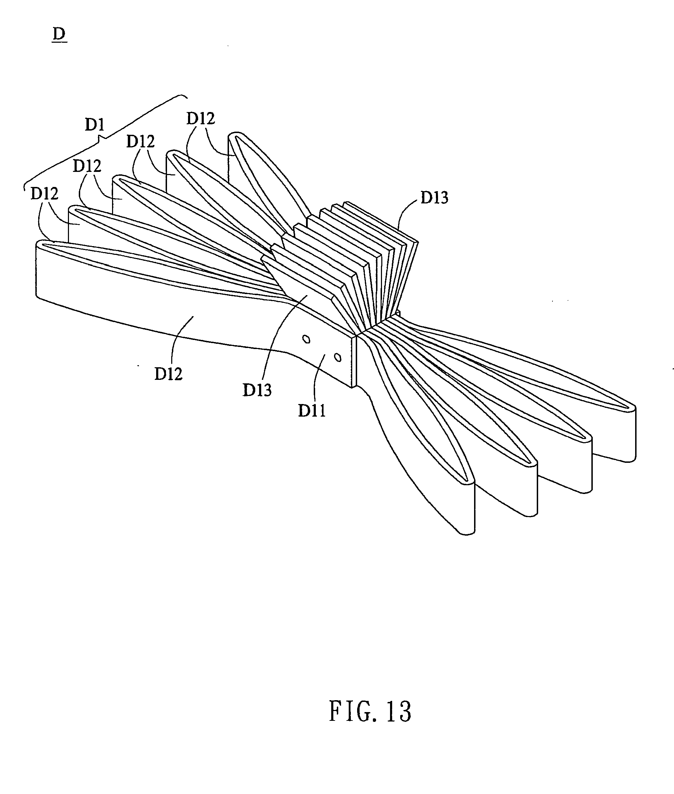

FIG. 13 is a three-dimensional view of a thermal-dissipating device D according to the thirteenth embodiment of the invention. The thermal-dissipating device D and the thermal-dissipating device B are different in that the thermal-dissipating sheet D1 of the thermal-dissipating device D further includes a plurality of thermal-dissipating portions D13, extending outwards from the connecting portions D11, respectively, and spreading out.

### Fourteenth embodiment: continuously-folded, double-layered, and double-sided

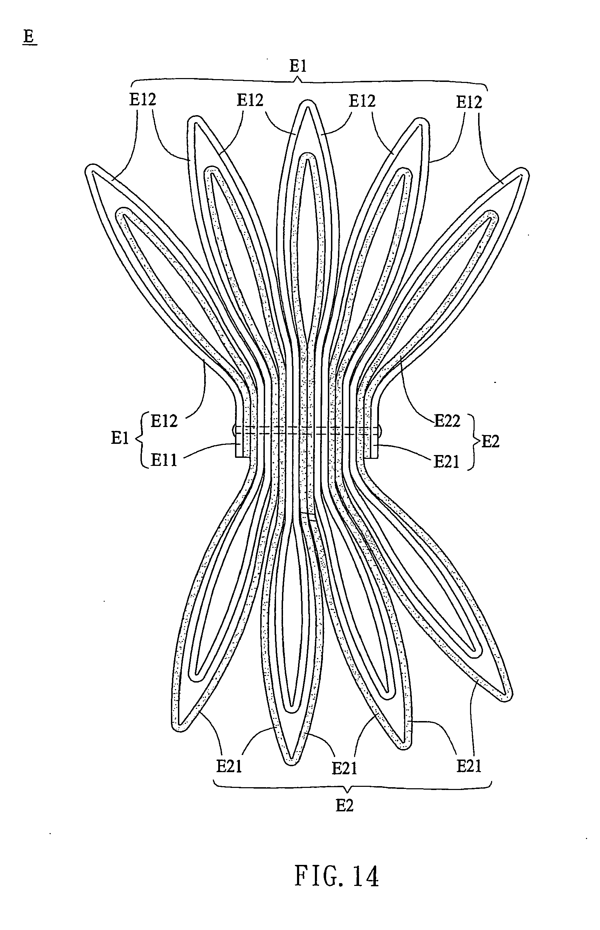

FIG. 14 is a top view of a thermal-dissipating device E according to the fourteenth embodiment of the invention. The thermal-dissipating device E and the thermal-dissipating device B are different in that the thermal-dissipating device E is formed by combining two thermal-dissipating sheets E1 and E2, whose shapes, sizes, and materials can be the same or different. Moreover, the thermal-dissipating sheets E1 and E2 can be disposed along the same or different directions, and be arranged side by side, in a crisscross way, or covered within each other (as shown in FIG. 14).

Besides, the thermal-dissipating device E can be configured with several thermal-dissipating portions to increase its thermal-dissipating efficiency. The positions of the thermal-dissipating portions are the same as described before and not repeated here again.

In summary, the thermal-dissipating device of the invention can have several different design aspects. For example, the thermal-dissipating sheets are bent once before they are stacked together or covered within each other. Alternatively, the thermal-dissipating sheets can be bent several times before they are stacked together or covered within each other. In comparison with the related art, the invention provides versatile designs that can increase the applicability and potential market.

## Claims

1. A thermal-dissipating device formed by connecting a plurality of thermal-dissipating sheets (11), the thermal-dissipating sheets (11) comprising:
a plurality of connecting portions (111) connected with each other; and
a plurality of thermal-dissipating fins (112) extended outwards from the connecting portion (111) respectively, **characterized in that** at least one set of the thermal-dissipating fins (112) is bent to be joined partially or totally at the ending sides.

2. The thermal-dissipating device of claim 1, wherein the shapes, sizes, and materials of the thermal-dissipating sheets (11) are the same or different.

3. The thermal-dissipating device of claim 1, wherein the connecting portion (111) is disposed on one end of the thermal-dissipating sheet (11), at the center of the thermal-dissipating sheet (11), or between one end and the center of the thermal-dissipating sheet (11).

4. The thermal-dissipating device of claim 1, wherein each of the thermal-dissipating sheets (11) further comprises:
at least one thermal-dissipating portion extended outwards from the connecting portion (111) in different directions from the thermal-dissipating fins (112).

5. A thermal-dissipating device formed by continuously bending at least one thermal-dissipating sheet (11) to render a plurality of bending sections, each of the bending sections comprising:
a connecting portion (111), wherein the connecting portions (111) are connected with each other; and
at least one thermal-dissipating fin (112) extended outwards from the connecting portion (111), **characterized in that** the thermal-dissipating fins (112) are bent to be joined partially or totally at the ending sides.

6. The thermal-dissipating device of claim 5, wherein when the thermal-dissipating device is formed by a plurality of thermal-dissipating sheets (11), the shapes, sizes, and materials of the thermal-dissipating sheets are the same or different.

7. The thermal-dissipating device of claim 2 or 6, wherein the thermal-dissipating sheets (11) are disposed side by side, in a crisscross way, or covered within each other.

8. The thermal-dissipating device of claim 7, wherein the thermal-dissipating sheets (11) are connected along the same direction or different directions.

9. The thermal-dissipating device of claim 5, wherein the connecting portion (111) is disposed on one end of the bending section, at the center of the bending section, or between one end and the center of the bending portion.

10. The thermal-dissipating device of claim 5, wherein each of the bending sections further comprises:
at least one thermal-dissipating portion (1713) extended outwards from the connecting portion (1711) in different directions from the thermal-dissipating fins (1712).

11. The thermal-dissipating device of claim 4 or 10, wherein the thermal-dissipating portions (1713) spread out from each other.

12. The thermal-dissipating device of claim 1 or 5, wherein the area of the thermal-dissipating fin (112) is larger than the area that of the connecting portion (111).

13. The thermal-dissipating device of claim 1 or 5, wherein the top edge of the thermal-dissipating fin (112) is higher than the top edge of the connecting portion (111).

14. The thermal-dissipating device of claim 1 or 5, wherein the bottom edge of the connecting portion (111) protrudes relative to the bottom edge of the thermal-dissipating fin (112).

## Patentansprüche

1. Wärme-ableitende Vorrichtung ausgebildet durch Verbinden einer Vielzahl von Wärme-ableitenden Blechen (11, 21, 31, 41, 51, 61, 71, 81, 91, A1, B1, 32, C1, D1, E1, E2), wobei jedes der Wärme-ableitenden Bleche (11, 21, 31, 41, 51, 61, 71, 81, 91, A1, B1, B2, C1, D1, E1, E2) umfasst:
eine Vielzahl von Verbindungs-Abschnitten (111, 211, 311, 411, 511, 611, 711, 811, 911, A11, B11, B21, C11, D11, E11, E21) die miteinander verbunden sind, und
eine Vielzahl von Wärme-ableienden Lamellen (112, 212, 312, 412, 512, 612, 712, 812, 912, A12, B12, B22, C12, E12, E22), die mit dem jeweiligen Verbindungs-Abschnitt (111, 211, 311 , 411, 511, 611, 711, 811, 911, A11, B11, B21, C11, D11, E11, E21) verbunden sind,
**dadurch gekennzeichnet, dass** mindestens ein Satz der Wärme-ableitenden Lamellen (112, 212, 312, 412, 512, 612, 712, 812, 912, A12, B12, B22, C12, E12, E22) gebogen ist, um teilweise oder ganz an den Endseiten zusammen gefügt zu sein.

2. Wärme-ableitende Vorrichtung nach Anspruch 1, wobei die Formen, Größen und Materialien der Wärme-ableitenden Bleche (11, 21, 31, 41, 51, 61, 71, 81, 91, A1, B1, B2, C1, D1, E1, E2) gleich oder unterschiedlich sind.

3. Wärme-ableitende Vorrichtung nach Anspruch 1, wobei der Verbindungs-Abschnitt (111, 211, 311, 411, 511, 611, 711, 811, 911, A11, B11, B21, C11, D11, E11, E21) an einem Ende des Wärme-ableitenden Blechs (11, 21, 31, 41, 51, 61, 71, 81, 91, A1, B1, B2, C1 D1, E1, E2), in der Mitte des Wärme-ableitenden Blechs (11, 21, 31, 41, 51, 61, 71, 81, 91, A1, B1, B2, C1, D1, E1, E2) oder zwischen einem Ende und der Mitte des Wärme-ableitenden Blechs (11, 21, 31, 41, 51, 61, 71, 81, 91, A1, B1, B2, C1, D1, E1, E2) angeordnet ist.

4. Wärme-ableitende Vorrichtung nach Anspruch 1, wobei jedes der Wärme-ableitenden Bleche (A1, D1) ferner umfasst:
mindestens einen Wärme-ableitenden Abschnitt (A13, D13), der sich nach außen von dem Verbindungs-Abschnitt (A11, D11) in unterschiedliche Richtungen von den Wärme-ableitenden Lamellen (A12, D12)erstreckt.

5. Wärme-ableitende Vorrichtung ausgebildet durch fortlaufendes Biegen mindestens eines Wärme-ableitenden Blechs (11, 21, 31, 41, 51, 61, 71, 81, 91, A1, B1, B2, C1, D1, E1, E2), um eine Vielzahl von Biegungs-Abschnitten bereitzustellen, wobei jeder Biegungs-Abschnitt umfasst:
einen Verbindungs-Abschnitt (111, 211, 311, 411, 511, 611, 711, 811, 911, A11, B11, B21, C11, D11, E11, E21), wobei die Verbindungs-Abschnitte (111, 211, 311, 411, 511, 611, 711, 811, 911, A11, B11, B21, C11, D11, E11, E21) miteinander verbunden sind, und
mindestens eine Wärme-ableitende Lamelle (112, 212, 312, 412, 512, 612, 712, 812, 912, A12, B12, B22, C12, E12, E22), die sich nach außen von dem Verbindungs-Abschnitt (111, 211, 311 ,411, 511, 611, 711, 811, 911, A11, B11, B21, C11, D11, E11, E21) erstreckt,
**dadurch gekennzeichnet, dass** die Wärme-ableitenden Lamellen (112, 212, 312, 412, 512, 612, 712, 812, 912, A12, B12, B22, C12, E12, E22) gebogen sind, um teilweise oder ganz an den Endseiten zusammen gefügt zu sein.

6. Wärme-ableitende Vorrichtung nach Anspruch 5, wobei, wenn die Wärme-ableitende Vorrichtung durch eine Vielzahl von Wärme-ableitenden Blechen (11, 21, 31, 41, 51, 61, 71, 81, 91, A1, B1, B2, C1 D1, E1, E2) ausgebildet ist, die Formen, Größen und Materialien der Wärme-ableitenden Bleche (11, 21, 31, 41, 51, 61, 71, 81, 91, A1, B1, B2, C1, D1, E1, E2) gleich oder unterschiedlich sind.

7. Wärme-ableitende Vorrichtung nach Anspruch 2 oder 6, wobei die Wärme-ableitenden Bleche (11, 21, 31, 41, 51, 61, 71, 81, 91, A1, B1, B2, C1, D1, E1, E2) nebeneinander kreuz und quer angeordnet sind, oder ineinander abgedeckt sind.

8. Wärme-ableitende Vorrichtung nach Anspruch 7, wobei die Wärme-ableitenden Bleche (11, 21, 31, 41, 51, 61, 71, 81, 91, A1, B1, B2, C1, D1, E1, E2) entlang derselben Richtung oder entlang verschiedener Richtungen verbunden sind.

9. Wärme-ableitende Vorrichtung nach Anspruch 5, wobei der Verbindungsabschnitt (111, 211, 311, 411, 511, 611, 711, 811, 911, A11, B11, B21, C11, D11, E11, E21) an einem Ende des Biegungs-Abschnitts, in der Mitte des Biegungs-Abschnitts, oder zwischen einem Ende und der Mitte des Biegungs-Abschnitts angeordnet ist.

10. Wärne-ableitende Vorrichtung nach Anspruch 5, wobei jeder der Biegungs-Abschnitte ferner umfasst:
mindestens einen Wärme-ableitenden Abschnitt (A13, B13), der sich nach außen von dem Verbindungs-Abschnitt (A11, D11) in unterschiedliche Richtungen von den Wärme-ableitenden Lamellen (A12, D12) erstreckt.

11. Wärme-ableitende Vorrichtung nach Anspruch 4 oder 10, wobei die Wärme-ableitenden Abschnitte (A13, D13) voneinander abgespreizt sind.

12. Wärme-ableitende Vorrichtung nach Anspruch 1 oder 5, wobei der Bereich der Wärme-ableitenden Lamellen (112, 212, 312, 412, 512, 612, 712, 812, 912, A12, B12, B22, C12, E12, E22) größer als der Bereich des Verbindungs-Abschnitt (111, 211, 311, 411, 511, 611, 711, 811, 911, A11, B11, B21, C11, D11, E11, E21) ist.

13. Wärme-ableitende Vorrichtung nach Anspruch 1 oder 5, wobei der obere Rand der Wärme-ableitenden Lamelle (112, 212, 312, 412, 512, 612, 712, 812, 912, A12, B 12, B22, C12, E12, E22) höher als der obere Rand des Verbindungs-Abschnitts (111, 211, 311, 411, 511, 611, 711, 811, 911, A11, B11, B21, C11, D11, E11, E21) ist.

14. Wärme-ableitende Vorrichtung nach Anspruch 1 oder 5, wobei der untere Rand des Verbindungs-Abschnitts (111, 211, 311, 411, 511, 611, 711, 811, 911, A11, B11, B21, C11 , D11, E11, E21) in Bezug auf den unteren Rand der Wärme-ableitenden Lamelle (112, 212, 312, 412, 512, 612, 712, 812, 912, A12, B12, B22, C12, E12, E22) hervorsteht.

## Revendications

1. Un dispositif de dissipation thermique formé par le raccordement d'une pluralité de feuilles de dissipation thermique (11, 21, 31, 41, 51, 61, 71, 81, 91, A1, B1, B2, C1, D1, E1, E2), les feuilles de dissipation thermique (11, 21, 31, 41, 51, 61, 71, 81, 91, A1, B1, B2, C1, D1, E1, E2) comportant:
une pluralité de parties de raccordement (111, 211, 311, 411, 511, 611, 711, 811, 911, A11, B11, B21, C11, D11, E11, E21) raccordés les unes aux autres; et
une pluralité d'ailettes de dissipation thermique (112, 212, 312, 412, 512, 612, 712, 812, 912, A12, B12, B22, C12, E12, E22) s'étendant vers l'extérieur de la partie de raccordement (111, 211, 311, 411, 511, 611, 711, 811, 911, A11, B11, B21, C11, D11, E11, E21), respectivement, **caractérisé en ce qu'**au moins un jeu d'ailettes de dissipation thermique (112, 212, 312, 412, 512, 612, 712, 812, 912, A12, B12, B22, C12, E12, E22) est courbé pour une jonction partielle ou totale aux extrémités.

2. Le dispositif de dissipation thermique de la revendication 1, dans lequel les formes, les dimensions et les matériaux des feuilles de dissipation thermique (11, 21, 31, 41, 51, 61, 71, 81, 91, A1, B1, B2, C1, D1, E1, E2) sont similaires ou différentes.

3. Le dispositif de dissipation thermique de la revendication 1, dans lequel la partie de raccordement (111, 211, 311, 411, 11, 611, 711, 811, 911, A11, B11, B21, C11, D11, E11, E21) est disposée à une extrémité de la feuille de dissipation thermique (11, 21, 31, 41, 51, 61,71, 81, 91, A1, B1, B2, C1, D1, E1, E2), au centre de la feuille de dissipation thermique (11, 21, 31, 41, 51, 61, 71, 81, 91, A1, B1, B2, C1, D1, E1, E2), ou entre une extrémité et le centre de la feuille de dissipation thermique (11, 21, 31, 41, 51, 61, 71, 81, 91, A1 B1, B2, C1, D1, E1, E2).

4. Le dispositif de dissipation thermique de la revendication 1, dans lequel chacune des feuille de dissipation thermique (A1, D1) comporte en outre:
au moins une portion de dissipation thermique (A13, D13) s'étendant vers l'extérieur depuis la partie de raccordement (A11, D11) suivant des directions différentes des ailettes de dissipation thermique (A12, D12).

5. Un dispositif de dissipation thermique formé au moyen de la courbure continue d'au moins une feuille de dissipation thermique (11, 21, 31, 41, 51, 61, 71, 81, 91, A1, R1, B2, C1, D1, E1, E2) afin de dégager une pluralité de section de courbure, chacune des sections de courbure comprenant:
une partie de raccordement (111, 211, 311, 411, 511, 611, 711, 811, 911, A11, B11, B21, C11, D11, E11, E21), dans laquelle la partie de raccordement (111, 211, 311, 411, 511, 611, 711, 811, 911, A11, B11, B21, C11, D11, E11, E21) est raccordée à une autre; et
au moins une ailette de dissipation thermique (112, 212, 312, 412, 512, 612, 712, 812, 912, A12, B12, B22, C12, E12, E22) s'étendant vers l'extérieur depuis la partie de raccordement (111, 211, 311, 411, 511, 611, 711, 811, 911, A11, B11, B21, C11, D11, E11, E21), **caractérisé en ce que** l'ailette de dissipation thermique (112, 212, 312, 412, 512, 612, 712, 812, 912, A12, B12, B22, C12, E12, E22) est recourbée pour une jonction partielle ou totale aux extrémités.

6. Le dispositif de dissipation thermique de la revendication 5, dans lequel lorsque le dispositif est formé d'une pluralité de feuilles de dissipation thermiques (11, 21, 31, 41, 51, 61, 71, 81, 91, A1, B1, B2, C1, D1, E1, E2), les formes, les dimensions et les matériaux des feuilles de dissipation thermique (11, 21, 31, 41, 51, 61, 71, 81, 91, A1, B1, B2, C1, D1, E1, E2) sont identiques ou différentes.

7. Le dispositif de dissipation thermique de la revendication 2 ou 6, dans lequel les feuilles de dissipation thermique (11, 21, 31, 41, 51, 61, 71, 81, 91, A1, B1, B2, C1, D1, E1, E2) sont disposées côté par côté, de manière croisée, ou se recouvrant les unes aux autres.

8. Le dispositif de dissipation thermique de la revendication 7, dans lequel les feuilles de dissipation thermique (11, 21, 31, 41, 51, 61, 71, 81, 91, A1, B1, B2, C1, D1, E1, E2) sont raccordées suivant la même direction ou suivant des directions différentes.

9. Le dispositif de dissipation thermique de la revendication 5, dans lequel la partie de raccordement (111, 211, 311, 411, 511, 611, 711, 811, 911, A11, B11, B21, C11, D11, E11, E21) est disposée à une extrémité de la section de courbure, au centre de la section de courbure, ou entre une extrémité et le centre de la section de courbure.

10. Le dispositif de dissipation thermique de la revendication 5, dans lequel chacune des sections de raccordement comporte en outre:
au moins une portion de dissipation thermique (A13, D13) s'étendant vers l'extérieur depuis la partie de raccordement (A11, D11) suivant différentes directions depuis les ailettes de dissipation thermique (A12, D12).

11. Le dispositif de dissipation thermique de la revendication 4 ou 10, dans lequel la portion de dissipation thermique (A13, D13) s'étale de l'une à l'autre.

12. Le dispositif de dissipation thermique de la revendication 1 ou 5, dans lequel la surface de l'ailette de dissipation thermique (112, 212, 312, 412, 512, 612, 712, 812, 912, A12, B12, B22, C12, E12, E22) est plus importante que la surface de la partie de raccordement (111, 211, 311, 411, 511, 611, 711, 811, 911, A11, 811, B21, C11, D11, E11, E21).

13. Le dispositif de dissipation thermique de la revendication 1 ou 5, dans lequel le bord supérieur de l'ailette de dissipation thermique (112, 212, 312, 412, 512, 612, 712, 812, 912, A12, B12, B22, C12, E12, E22) est plus élevée que le bord supérieur de la partie de raccordement (111, 211, 311, 411, 511, 611, 711, 811, 911, A11, B11, B21, C11, D11, E11, E21),

14. Le dispositif de dissipation thermique de la revendication 1 ou 5, dans lequel le bord inférieur de la partie de raccordement (111, 211, 311, 411, 511, 611, 711, 811, 911, A11, B11, B21, C11, D11, E11, E21) se déporte par rapport au bord inférieur de l'ailette de dissipation thermique (112, 212, 312, 412, 512, 612, 712, 812, 912, A12, B12, B22, C12, E12, E22).
